# EUROPEAN PATENT APPLICATION

(11) **EP 1 026 762 A1**
(43) Date of publication of application: **09.08.2000**
(21) Application number: 00300977.6
(22) Date of filing: 08.02.2000
(51) Int. Cl.: H01M 4/02, H01M 4/04, C23C 16/30, C23C 16/40, H01G 9/00

(54) **Chemical vapor deposited electrode component and method of manufacture**

(30) Priority: 08.02.1999 US 119012 P
(71) Applicant: WILSON GREATBATCH LTD., Clarence New York 14031 (US)
(72) Inventor: Muffoletto, Barry C., Alden, New york 14004 (US); Shah, Ashish, East Amherst, New York 14051 (US); Nesselbeck,Neal, Lockport, New York 14094 (US)
(74) Representative: Colmer, Stephen Gary

(57) **Abstract**

An electrode component for an electrochemical cell is described wherein the electrode is produced by chemical vapor depositing an electrode active material onto a substrate to coat the substrate. The thusly produced electrode is useful as a cathode in a primary electrochemical cell and as a cathode and an anode in a secondary cell, and as an electrode in an electrochemical capacitor and an electrolytic capacitor.

## Description

### BACKGROUND OF THE INVENTION

### 1. Field Of The Invention

The present invention generally relates to the art of electrical energy storage devices and more particularly, to an electrode of an electrochemical cell or capacitor produced by a chemical vapor deposition process.

### 2. Prior Art

Chemical vapor plating involves vaporizing a volatile compound of a substance of interest and as the compound is deposited on a substrate, thermally decomposing the compound at the substrate to yield the desired plated coating. Halides including chlorides and iodides, metal carbonyls and metal hydrides are typically used when the resulting film contains a metal. For some volatile compounds, high temperature alone is sufficient to decompose the feed stock gas. Others require a combination of high temperature and a reducing agent such as hydrogen. Depending on the substance of interest, deposition is conducted by reacting the feed stock gas with the substrate or with a reactive coating on the substrate, either at atmospheric or reduced pressures. Accordingly, chemical vapor plating is typically used with materials having relatively high melting points and for growing epitaxial single crystal films, for example, of silicon for use in semiconductors.

### SUMMARY OF THE INVENTION

The present invention is directed to a novel and unique application of the chemical vapor deposition process. The present process provides a coating of an electrochemically active material on a substrate, preferably a conductive substrate. The thusly produced coated substrate is useful as an electrode, for example, a cathode electrode incorporated into a primary electrochemical cell, and as the anode and/or the cathode of a secondary electrochemical cell. The assembly of the cell incorporating the electrode component made by chemical vapor depositing an electrode active material onto a conductive substrate according to the present invention is preferably in the form of a wound element cell. That is, the fabricated cathode together with an anode and a separator are wound together in a "jellyroll" end type configuration or a "wound element cell stack" such that the anode is on the outside of the roll to make electrical contact with the cell case in a case-negative configuration. Other types of cells such as prismatic, bobbin shape and flat cells are also possible with the present invention.

In the case of a capacitor, the present chemical vapor deposition process is useful for producing an anode or a cathode in an electrochemical capacitor or the cathode in an electrolytic capacitor. Regardless the type, the capacitor configuration generally includes a substrate of a conductive metal such as titanium or tantalum provided with a semiconductive or a pseudocapacitive oxide coating, nitride coating, carbon nitride coating, or carbide coating.

### DETAILED DESCRIPTION OF THE PREFERRED EMBODIMENTS

One embodiment of the present invention is directed to the use of a chemically vapor deposited coating of an electrode active material on a conductive substrate to thereby form an electrode component for an electrochemical cell. In one preferred embodiment, the electrode active material is a cathode active material deposited onto a substrate by means of a chemical vapor deposition process, including plasma assisted chemical vapor deposition, to form a cathode component for an electrochemical cell. The cathode active material is selected from the group consisting of a metal, a metal oxide, mixed metal oxide, a metal sulfide and a carbonaceous material, and mixtures thereof. Suitable cathode materials include silver vanadium oxide, copper silver vanadium oxide, manganese dioxide, titanium disulfide, copper oxide, cobalt oxide, chromium oxide, copper sulfide, iron sulfide, iron disulfide, carbon and fluorinated carbon. The solid cathode exhibits excellent thermal stability and is generally safer and less reactive than a non-solid cathode.

Preferably, the solid cathode material comprises a mixed metal oxide formed by chemical vapor depositing various metal oxides or metal oxide/elemental metal combinations. The materials thereby produced contain metals and oxides of Groups IB, IIB, IIIB, IVB, VB, VIB, VIIB and VIII of the Periodic Table of Elements, which includes the noble metals and/or their oxide compounds.

By way of illustration, and in no way intended to be limiting, an exemplary cathode active material comprises silver vanadium oxide having the general formula AgₓV₂O_{y} in any one of its many phases, i.e. β-phase silver vanadium oxide having in the general formula x = 0.35 and y = 5.18, γ-phase silver vanadium oxide having in the general formula x = 0.74 and y = 5.37 and ε-phase silver vanadium oxide having in the general formula x = 1.0 and y = 5.5, and combination and mixtures of phases thereof. Preferably, the cathode active material, whether comprised of silver vanadium oxide or a similarly suitable material, is deposited onto a substrate of titanium, stainless steel, nickel, tantalum, platinum, gold or aluminum by a chemical vapor deposition process. The thusly formed exemplary electrode can be incorporated into an alkali metal electrochemical cell, and more particularly, a lithium electrochemical cell.

Another preferred embodiment of the present invention comprises coating an alkalated material onto a conductive substrate of the above described materials by a chemical vapor deposition process, including plasma assisted chemical vapor deposition, to provide a cathode for a secondary electrochemical cell. For example, in the case of the alkalated material being a lithiated material suitable materials include oxides, sulfides, selenides and tellurides of such metals as vanadium, titanium, chromium, copper, tin, molybdenum, niobium, iron, nickel, cobalt and manganese. Among the suitable oxides are LiNiO₂, LiMn₂O₄, LiCoO₂, LiCo_{0.92}Sn_{0.08}O₂ and LiCo₁₋ₓNiₓO₂. The anode for such a secondary electrochemical cell can comprise a particulate carbonaceous composition including carbon together with a filamentary, electrically conductive material such as carbon black. Accordingly, it is further contemplated by the scope of the present invention that particulate carbonaceous compositions are chemically vapor deposited onto a conductive substrate for use as an anode component in a secondary cell and as the cathode in a primary electrochemical cell.

Chemical vapor deposited coatings including plasma assisted chemical vapor deposition rely mostly upon mechanical bonding to the substrate surface. It is therefore critical that the electrode substrate be properly prepared to ensure coating quality. It is especially necessary that the surface remain uncontaminated by lubricants from handling equipment or body oils from the hands. Suitable substrate surface preparation techniques include scraping, wire brushing, machining, grit blasting, or by chemical action. It also is recommended that the prepared surface be coated as soon as possible after preparation to prevent the possibility of contamination or surface oxidation.

After substrate surface cleaning, surface roughness is the next most critical factor for properly applying a chemical vapor deposited coating of electrode active material. Three methods of roughening the electrode substrate surface are appropriate and they consist of rough threading, grit blasting, and a combination of rough threading, then grit blasting, as are well known to those skilled in the art of chemical vapor deposition techniques. According to the present invention any one of the previously listed electrode active materials including the enumerated cathode active materials and the lithiated materials is provided as a volatile compound of a halide (chlorides or iodides), a carbonyl or a hydride. A vapor phase of the volatile plating compound is then generated by evaporation which is accomplished either by heating the volatile compound or by passing a reactive gas over or through the electrode active material compound. Gas flow provides a continuous supply of reactive gas to the substrate, however, actual transfer of the volatile compound is a diffusion mechanism. When the volatile compound impinges on the heated substrate, the volatile component is evaporated leaving a deposit or the electrode active material. The volatile by-products are transported from the substrate to complete the deposition process. If desired, a low pressure plasma or a high pressure plasma is used to assist the deposition process.

One of the benefits of the present invention is that electrode plates made by a chemical vapor deposition process according to the present invention are thinner than currently available electrodes. This provides for the manufacture of higher surface area cells housed in smaller containers than conventional electrode preparation technology permits. In that respect, the electrode active material can be coated on both sides of the substrate by a chemical vapor deposition process to further increase the electrode active surface area. The substrate can also be perforated so that the coatings on both sides of the substrate are in physical contact with each other to lock the electrode active material onto the substrate.

The exemplary cell of the present invention having the cathode component made by the chemical vapor deposition of a cathode active material onto a suitable substrate and preferably silver vanadium oxide deposited onto a titanium substrate, further comprises an anode selected from Group IA of the Periodic Table of Elements, including lithium, sodium, potassium, etc., and their alloys and intermetallic compounds including, for example Li-Si, Li-B and Li-Si-B alloys and intermetallic compounds. The preferred anode comprises lithium.

The form of the anode may vary, but preferably the anode is a thin metal sheet or foil of the anode metal, pressed or rolled on a metallic anode current collector, i.e., preferably comprising nickel to form an anode component. In the electrochemical cell of the present invention, the anode component has an extended tab or lead of the same material as the anode current collector, i.e., preferably nickel integrally formed therewith such as by welding and contacted by a weld to a cell case of conductive metal in a case-negative electrical configuration. Alternatively, the anode may be formed in some other geometry, such as a bobbin shape, cylinder or pellet to allow an alternate low surface area cell design.

The exemplary cell of the present invention having the cathode component made by chemical vapor depositing a cathode active material onto a suitable substrate includes a separator to provide physical separation between the anode and cathode active electrodes. The separator is of electrically insulative material to prevent an internal electrical short circuit between the electrodes, and the separator material also is chemically unreactive with the anode and cathode active materials and both chemically unreactive with and insoluble in the electrolyte. In addition, the separator material has a degree of porosity sufficient to allow flow therethrough of the electrolyte during the electrochemical reaction of the cell. Illustrative separator materials include non-woven glass, polypropylene, polyethylene, glass fiber material, ceramics, a polytetrafluorethylene membrane commercially available under the designations ZITEX (Chemplast Inc.), a polypropylene membrane commercially available under the designation CELGARD (Celanese Plastic Company Inc.) and DEXIGLAS (C.H. Dexter, Div., Dexter Corp.). Other separator materials that are useful with the present invention include woven fabric separators comprising halogenated polymeric fibers, for example of the type described in U.S. Patent No. 5,415,959 to Pyszczek et al., which is assigned to the assignee of the present invention and incorporated herein be reference. Other suitable halogenated polymeric materials include, but are not limited to, polyethylene tetrafluoroethylene which is commercially available under the name Tefzel, a trademark of the DuPont Company; polyethylenechlorotrifluoroethylene which is commercially available under the name Halar, a trademark of the Allied Chemical Company and polyvinylidine fluoride.

The form of the separator typically is a sheet which is placed between the anode and cathode electrodes and in a manner preventing physical contact therebetween. Such is the case when the anode is folded in a serpentine-like structure with a plurality of cathode plates disposed intermediate the anode folds and received in a cell casing or when the electrode combination is rolled or otherwise formed into a cylindrical "jellyroll" configuration.

The exemplary electrochemical cell of the present invention having the cathode component made by chemical vapor depositing a cathode active material onto a suitable substrate further includes a nonaqueous, ionically conductive electrolyte activating the anode and the cathode electrodes. The electrolyte serves as a medium for migration of ions between the anode and the cathode during the electrochemical reactions of the cell. The electrochemical reactions at the electrodes involves conversion of the migrating ions into atomic or molecular forms. Thus, nonaqueous electrolytes suitable for the present invention are substantially inert to the anode and cathode materials, and they exhibit those physical properties necessary for ionic transport, namely, low viscosity, low surface tension and wettability.

A suitable electrolyte has an inorganic, ionically conductive salt dissolved in a nonaqueous solvent, and more preferably, the electrolyte includes an ionizable alkali metal salt dissolved in a mixture of aprotic organic solvents comprising a low viscosity solvent and a high permittivity solvent. The ionically conductive salt serves as the vehicle for migration of the anode ions to intercalate or react with the cathode active material. In a solid cathode/electrolyte system, the preferred ion-forming alkali metal salt is similar to the alkali metal comprising the anode. Examples of salts useful with the present invention include LiPF₆, LiAsF₆, LiSbF₆, LiBF₄, LiAlCl₄, LiNO₃, LiGaCl₄, LiSO₃F, LiB(C₆H₅)₄, LiClO₄, LiC(SO₂CF₃)₃, LiSCN, LiO₃SCF₂CF₃, LiC₆F₅SO₃, LiO₂CCF₃, LiN(SO₂CF₃)₂ and LiCF₃SO₃, and mixtures thereof.

Low viscosity solvents include tetrahydrofuran (THF), methyl acetate (MA), diglyme, trigylme, tetragylme, dimethyl carbonate (DMC), 1,2-dimethoxyethane (DME), diethyl carbonate, diisopropylether, 1,2-diethoxyethane (DEE), 1-ethoxy, 2-methoxyethane (EME), dipropyl carbonate (DPC), ethylmethyl carbonate (EMC), methyipropyl carbonate (MPC) and ethylpropyl carbonate (EPC), and mixtures thereof, and high permittivity solvents include cyclic carbonates, cyclic esters and cyclic amides such as propylene carbonate (PC), butylene carbonate (BC), ethylene carbonate (EC), acetonitrile, dimethyl sulfoxide, dimethyl formamide, dimethyl acetamide, γ-valerolactone, γ-butyrolactone (GBL) and N-methylpyrrolidinone (NMP) and mixtures thereof. In the preferred electrochemical cell comprising the Li/SVO or the Li/CSVO couple, the preferred electrolyte is 1.0M to 1.4M LiPF₆ or LiAsF₆ in a 50:50 mixture, by volume, of PC and DME.

One preferred form of the cell assembly described herein is referred to as a wound element cell. That is, the fabricated cathode, anode and separator are wound together in a "jellyroll" end type configuration or "wound element cell stack" such that the anode is on the outside of the roll to make electrical contact with the cell case in a case negative configuration. Using suitable top and bottom insulators, the wound cell stack is inserted into a metallic case of a suitable size dimension. The metallic case may comprise materials such as stainless steel, mild steel, nickel-plated mild steel, titanium or aluminum, but not limited thereto, so long as the metallic material is compatible for use with components of the cell.

The cell header comprises a metallic disc-shaped body with a first hole to accommodate a glass-to-metal seal/terminal pin feedthrough and a hole for electrolyte filling. The glass used is of a corrosion resistant type having from between about 0% to about 50% by weight silicon such as CABAL 12, TA 23 or FUSITE 425 or FUSITE 435. The positive terminal pin feedthrough preferably comprises titanium although molybdenum and aluminum can also be used. The cell header comprises elements having compatibility with the other components of the electrochemical cell and is resistant to corrosion. The cathode lead is welded to the positive terminal pin in the glass-to-metal seal and the header is welded to the case containing the electrode stack. The cell is thereafter filled with the electrolyte described hereinabove and hermetically sealed such as by close-welding a stainless steel ball over the fill hole, but not limited thereto. This above assembly describes a case negative cell which is the preferred construction of the exemplary cell of the present invention. As is well known to those skilled in the art, the exemplary electrochemical system of the present invention can also be constructed in a case positive configuration.

Another embodiment of the present invention is directed to the use of a chemically vapor deposited coating of a semiconductive or pseudocapacitive oxide coating, nitride coating, carbon nitride coating, or carbide coating. The coating is deposited on a substrate of a conductive metal such as titanium, molybdenum, tantalum, niobium, cobalt, nickel, stainless steel, tungsten, platinum, palladium, gold, silver, copper, chromium, vanadium, aluminum, zirconium, hafnium, zinc and iron, and mixtures and alloys thereof. The semiconductive or pseudocapacitive material includes a volatile compound of a halide (chloride or iodide), a carbonyl or a hydride of the oxide of a first metal, or a precursor thereof, the nitride of the first metal, or a precursor thereof, the carbon nitride of the first metal, or a precursor thereof, and/or the carbide of the first metal, or a precursor thereof, the oxide, nitride, carbon nitride and carbide of the first metal having pseudocapacitive properties. The first metal is preferably selected from the group consisting of ruthenium, cobalt, manganese, molybdenum, tungsten, tantalum, iron, niobium, iridium, titanium, zirconium, hafnium, rhodium, vanadium, osmium, palladium, platinum, and nickel. For example, in the case where it is intended that the resulting pseudocapacitive coating is an oxide of one of the above listed first metals, the deposited mixture can include a nitrate or a chloride of the metal.

The porous coating may also include a second or more metals. The second metal is in the form of an oxide, a nitride, a carbon nitride or a carbide, or precursors thereof and is not essential to the intended use of the coated foil as a capacitor electrode and the like. The second metal is different than the first metal and is selected from one or more of the group consisting of tantalum, titanium, nickel, iridium, platinum, palladium, gold, silver, cobalt, molybdenum, ruthenium, manganese, tungsten, iron, zirconium, hafnium, rhodium, vanadium, osmium, and niobium. In a preferred embodiment of the invention, the porous coating includes oxides or ruthenium and tantalum, or precursors thereof.

The thusly fabricated semiconductive or pseudocapacitive coated substrates are useful as an anode or a cathode in an electrochemical capacitor or the cathode in an electrolytic capacitor. For additional disclosure directed to such capacitors, reference is made to U.S. patent application Serial No. 08/847,948, filed May 1, 1997, which is assigned to the assignee of the present invention and incorporated herein by reference. For a more thorough understanding of the chemical vapor deposition process, reference is made to the book Vapor Deposition, edited by Carroll F. Powell, Joseph H. Oxley and John M. Blocker, Jr. of the Battelle Memorial Institute, Columbus, Ohio, published by John Wiley Sons, Inc., the disclosure of which is incorporated herein by reference.

It is appreciated that various modifications to the invention concepts described herein may be apparent to those skilled in the art without departing from the spirit and the scope of the present invention defined by the hereinafter appended claims.

The present invention also provides for the following embodiments; a method of manufacturing a cathode of an electrochemical cell which includes roughening the substrate surface prior to chemical vapor deposition of the cathode active material thereon; a method of manufacturing a cathode of an electrochemical cell which includes perforating the substrate prior to chemical vapor depositing the cathode active material thereon; and a method of manufacturing an electrochemical cell, comprising the steps of:
a) providing a casing of an electrically conductive material;
b) providing an anode disposed inside the casing;
c) providing a cathode current collector;
d) chemical vapor depositing a coating of cathode active material onto the cathode current collector to provide a cathode;
e) positioning the cathode and the anode inside the casing; and
f) activating the anode and the cathode with an ionically conductive electrolyte filled in the casing.

## Claims

1. A method for manufacturing an electrode component for an electrochemical cell or a capacitor which comprises
a) providing a substrate
b) providing on said substrate a layer of electrode active material by chemical vapor deposition.

2. A method as claimed in claim 1 wherein the electrode component is a cathode of an electrochemical cell and the layer of electrode active material is cathode active material.

3. A method as claimed in claim 1 or 2 wherein the substrate is electrically conductive.

4. A method as claimed in any one of the preceding claims wherein the substrate is flexible.

5. A method as claimed in any one of the preceding claims wherein the substrate is selected from the group consisting of titanium, stainless steel, nickel, tantalum, platinum, aluminum, and gold, and mixtures thereof.

6. A method as claimed in any one of the preceding claims wherein the substrate comprises titanium or aluminum or mixtures thereof.

7. The method as claimed in any one of claims 2 to 6 wherein the cathode active material is selected from the group consisting of a metal, a metal oxide, a mixed metal oxide, a metal sulfide and a carbonaceous material, and mixtures thereof.

8. The method as claimed in any one of claims 2 to 7 wherein the cathode active material is selected from the group consisting of silver vanadium oxide, copper silver vanadium oxide, manganese dioxide, titanium disulfide, copper oxide, chromium oxide, copper sulfide, iron sulfide, iron disulfide, cobalt oxide, nickel oxide, carbon and fluorinated carbon, and mixtures thereof.

9. The method as claimed in any one of claims 2 to 8 wherein the layer of the cathode active material is characterised as a chemical vapor deposition product having a thickness of from 0.0254 mm (0.001 inches) to 10.16 mm (0.4 inches).

10. The method as claimed in any one of claims 1 to 9 wherein the substrate has been cleaned and provided with a roughened surface texture.

11. The method as claimed in any one of claims 1 to 10 wherein the substrate is perforated.

12. The method as claimed in claim 11 wherein said perforated substrate is provided by chemical vapor deposition with a layer of cathode active material on both of its sides to lock the cathode active material onto the substrate through the perforations.

13. The method as claimed in any of the preceding claims which comprises providing on said substrate a layer of electrode active material by plasma assisted chemical deposition.

14. An electrode component obtainable by the method of any of the preceding claims.

15. A method of manufacturing an electrochemical cell having a solid cathode, an anode and an ionically conductive electrolyte activating the anode and the cathode wherein the cathode is manufactured according to the method of any one of claims 2 to 13.

16. A method as claimed in claim 15 wherein the anode comprises a Group IA metal.

17. A method as claimed in claims 15 or 16 wherein the anode comprises lithium.

18. A method as claimed in any one of claims 15 to 17 wherein the electrolyte solution operatively associated with the anode and the cathode comprises an ion-forming alkali metal salt dissolved in a nonaqueous solvent, wherein the alkali metal of the salt is the same as the alkali metal comprising the anode.

19. A method as claimed in any one of claims 15 to 18 wherein the alkali metal of the anode comprises lithium and the ion-forming alkali metal salt comprising the electrolyte solution is selected from the group consisting of LiPF₆, LiAsF₆, LiSbF₆, LiBF₄, LiClO₄, LiAlCl₄, LiGaCl₄, LiC(SO₂CF₃)₃, LiN(SO₂CF₃)₂, LiSCN, LiO₃SCF₂CF₃, LiC₆F₅SO₃, LiO₂CCF₃, LiSO₃F, LiB(C₆H₅)₄ and LiCF₃SO₃, and mixtures thereof.

20. A method as claimed in any one of claims 15 to 19 wherein the nonaqueous solvent comprises at least one organic solvent selected from the group consisting of tetrahydrofuran, methyl acetate, diglyme, triglyme, tetraglyme, dimethyl carbonate, 1,2-dimethoxyethane, 1,2-diethoxyethane, 1-ethoxy, 2-methoxyethane, diethyl carbonate, acetonitrile, dimethyl sulfoxide, dimethyl formamide, dimethyl acetamide, propylene carbonate, ethylene carbonate, γ-valerolactone, γ-butyrolactone and N-methyl-pyrrolidinone, and mixtures thereof.

21. A method as claimed in any one of claims 15 to 20 wherein a separator is provided between the anode and the cathode to prevent internal short circuit contact between them

22. A method as claimed in any one of claims 15 to 21 wherein the electrochemical cell is housed in a conductive casing comprising a material selected from the group consisting of titanium, stainless steel, mild steel, nickel, nickel-plated mild steel and aluminum.

23. A method as claimed in any one of claims 15 to 22 wherein the anode comprises lithium anode active material in electrical contact with a nickel current collector and the cathode comprises silver vanadium oxide active material in electrical contact with a titanium current collector and wherein the anode and the cathode are activated with the electrolyte solution comprising 1.0M LiAsF₆ in a 50:50 mixture, by volume, of propylene carbonate and 1,2-dimethoxyethane.

24. A method as claimed in any one of claims 15 to 22 wherein the anode comprises lithium, the cathode comprises silver vanadium oxide as the cathode active material physical vapor deposited onto the substrate comprising titanium and the electrolyte comprises LiPF₆ dissolved in an organic solvent.

25. A method of manufacturing a secondary electrochemical cell having a casing, a negative electrode comprising negative active material which intercalates with lithium, a positive electrode and an electrolyte activating the negative and positive electrodes wherein the positive electrode is an electrode component manufactured by the method of any one of claims 1, 3 to 6 and 10 to 13 and wherein the electrode active material is positive electrode active material selected from the group consisting of lithiated oxides, lithiated sulfides, lithiated selenides and lithiated tellurides of at least one selected from the group consisting of vanadium, titanium, chromium, copper, tin, molybdenum, niobium, iron, nickel, cobalt and manganese, and mixtures thereof.

26. A method as claimed in any one of claims 15 to 25 which further comprises
a) providing a casing of an electrically conductive material
b) disposing the anode inside the casing
c) positioning the cathode and the anode inside the casing; and
d) activating the anode and the cathode with an ionically conductive electrolyte filled in the casing.

27. An electrochemical cell obtainable by the method of any of claims 15 to 26.

28. A method of manufacturing a capacitor having a casing, a first electrode, a counterelectrode and an electrolyte activating the first electrode and the counterelectrode wherein the first electrode is manufactured by the method of any of claims 1, 3 to 6 and 10 to 13 and the electrode active material is a first, pseudocapacitive metal compound comprising a first metal or a precursor thereof selected from the group consisting of an oxide, a nitride, a carbon nitride and a carbide, and mixtures thereof.

29. A method as claimed in claim 28 wherein the first metal is selected from the group consisting of ruthenium, molybdenum, tungsten, tantalum, cobalt, manganese, nickel, iridium, iron titanium, zirconium, hafnium, rhodium, vanadium, osmium, palladium, platinum and niobium, and mixtures thereof.

30. A method as claimed in claim 28 or 29 wherein the layer includes a second metal selected from the group consisting of tantalum, titanium, nickel, iridium, platinum, palladium, gold, silver, cobalt, molybdenum, niobium, ruthenium, manganese, tungsten, iron, zirconium, hafnium, rhodium, vanadium, osmium, and mixtures thereof.

31. A method as claimed in any one of claims 28 to 30 wherein the coating is comprised of ruthenium and tantalum.

32. A method as claimed in any one of claims 28 to 31 wherein the substrate is selected from the group consisting of tantalum, titanium, nickel, molybdenum, niobium, cobalt, stainless steel, tungsten, platinum, palladium, gold, silver, copper, chromium, vanadium, aluminum, zirconium, hafnium, zinc and iron, and mixtures thereof.

33. A capacitor obtainable by the method of any of claims 28 to 32.
